# EUROPÄISCHE PATENTSCHRIFT

(11) **EP 2 436 045 B1**
(45) Veröffentlichungstag und Bekanntmachung des Hinweises auf die Patenterteilung: **25.01.2017**
(21) Anmeldenummer: 10713203.7
(22) Anmeldetag: 08.04.2010
(51) Int. Cl.: H01L 33/22, H01L 33/50

(54) **OPTOELEKTRONISCHER HALBLEITERCHIP UND VERFAHREN ZUR HERSTELLUNG EINES OPTOELEKTRONISCHEN HALBLEITERCHIPS**
OPTOELECTRONIC SEMICONDUCTOR CHIP AND METHOD FOR PRODUCING AN OPTOELECTRONIC SEMICONDUCTOR CHIP
PUCE OPTOÉLECTRONIQUE SEMI-CONDUCTRICE ET PROCÉDÉ DE FABRICATION D'UNE PUCE OPTOÉLECTRONIQUE SEMI-CONDUCTRICE

(30) Priorität: 29.05.2009 DE 102009023351
(43) Veröffentlichungstag der Anmeldung: 04.04.2012
(73) Patentinhaber: OSRAM Opto Semiconductors GmbH, 93055 Regensburg (DE)
(72) Erfinder: GMEINWIESER, Nikolaus, 93093 Donaustauf (DE); HAHN, Berthold, 93155 Hemau (DE)
(74) Vertreter: Epping - Hermann - Fischer
(86) Internationale Anmeldenummer: PCT/EP2010/054662
(87) Internationale Veröffentlichungsnummer: WO 2010/136251

(56) Entgegenhaltungen:
- WO-A1-01/24283
- WO-A1-2009/039815
- WO-A2-2008/060586
- WO-A2-2009/048704
- US-A1- 2006 258 028
- US-A1- 2008 217 639

## Beschreibung

Es wird ein optoelektronischer Halbleiterchip angegeben. Darüber hinaus wird ein Verfahren zur Herstellung eines optoelektronischen Halbleiterchips angegeben.

In der Druckschrift US 2007/0221867 A1 ist ein Wellenlängenkonversionschip angegeben.

Die Druckschrift WO 2009/048704 A2 betrifft eine Leuchtdiode mit einer gebondeten Halbleiterkonversionsschicht.

Ein Verfahren zur Kontrolle einer von einer Leuchtdiode emittierten Strahlung findet sich in der Druckschrift US 2006/0258028 A1.

Die Beschreibung einer Leuchtdiode mit einem Dünnfilmkonversionselement ist in der Druckschrift WO 01/24283 A1 wiedergegeben.

Eine strukturierte Konversionsmittelschicht ist in der Druckschrift WO 2008/060586 A2 offenbart.

Die Druckschrift US 2008/0217639 A1 betrifft eine Leuchtdiode mit einem photonischen Kristall.

Aus der Druckschrift WO 2009/039815 A1 ist ein strahlungsemittierender Halbleiterkörper bekannt.

Eine zu lösende Aufgabe besteht darin, einen optoelektronischen Halbleiterchip anzugeben, bei dem ein Farbort einer zu emittierenden Strahlung effizient einstellbar ist. Eine weitere zu lösende Aufgabe besteht darin, ein Herstellungsverfahren für einen solchen Halbleiterchip anzugeben.

Diese Aufgabe wird gelöst durch einen Halbleiterchip und durch ein Verfahren mit den Merkmalen der unabhängigen Patentansprüche.

Der optoelektronische Halbleiterchip umfasst mindestens eine Halbleiterschichtenfolge. Die Halbleiterschichtenfolge ist beispielsweise epitaktisch gewachsen. Zum Beispiel basiert die Halbleiterschichtenfolge auf GaN, InGaN, InGaAlN, GaP, InGaAlP, InGaAs oder GaAs. Bevorzugt ist die Halbleiterschichtenfolge als Dünnfilmschichtenfolge ausgebildet. Mit anderen Worten ist eine Dicke der Halbleiterschichtenfolge bevorzugt kleiner oder gleich 12 µm, insbesondere kleiner oder gleich 8 µm.

Es beinhaltet die Halbleiterschichtenfolge mindestens eine aktive Schicht. Die aktive Schicht ist zur Erzeugung einer elektromagnetischen Primärstrahlung eingerichtet. Bevorzugt beinhaltet die Schicht wenigstens eine Quantentopfstruktur, bevorzugt eine Mehrzahl von Quantentopfstrukturen.
Beispielsweise ist die aktive Schicht eine Multiquantentopfstruktur, kurz MQW. Die Primärstrahlung weist bevorzugt Wellenlängen im ultravioletten und/oder blauen Spektralbereich auf oder auch im blau-grünen oder grünen Spektralbereich.

Es umfasst die Halbleiterschichtenfolge eine Mehrzahl von Konversionsschichten. Es bestehen die Konversionsschichten also insbesondere aus einem Halbleitermaterial. Die Konversionsschichten, die zum Beispiel durch zumindest eine Quantentopfstruktur gebildet sind, sind dazu eingerichtet, die Primärstrahlung vollständig oder teilweise zu absorbieren und die absorbierte Primärstrahlung in eine gegenüber der Primärstrahlung längerwellige Sekundärstrahlung umzuwandeln. Bevorzugt sind die Konversionsschichten der mindestens einen aktiven Schicht in einer Abstrahlrichtung der aktiven Schicht nachgeordnet. Die Konversionsschichten sind also elektrisch inaktiv, das heißt, die Konversionsschichten werden nicht elektrisch, sondern optisch gepumpt.

Es weist die Halbleiterschichtenfolge eine Aufrauung auf. Die Aufrauung ist zum Beispiel durch eine Vielzahl von Gräben gebildet. Mit anderen Worten kann die Aufrauung eine Dickenmodulation der Halbleiterschichtenfolge sein. Die Aufrauung kann durch einen fotolithographischen Prozess und/oder durch ein Ätzen erzeugt sein. Die Aufrauung kann regelmäßig oder auch zufällig strukturiert sein.

Es reicht die Aufrauung durch die Konversionsschichten. Mit anderen Worten ist die Aufrauung durch eine stellenweise Dickenreduzierung der Halbleiterschichtenfolge gebildet. Durch die Aufrauung erfolgt bei den Konversionsschichten eine Materialwegnahme. Das heißt, es sind zum Beispiel eine Vielzahl von Gräben oder Rillen bevorzugt in eine der aktiven Schicht abgewandte Oberseite der Halbleiterschichtenfolge gebildet, wobei die Gräben oder Rillen so weit in die Halbleiterschichtenfolge hineinreichen, dass ein Material der Konversionsschichten teilweise entfernt ist. Gräben oder Rillen sind zum Beispiel im Querschnitt V-förmige Materialwegnahmen aus der Halbleiterschichtenfolge. Die Aufrauung kann auch durch Erhebungen gebildet sein, die sich über die Halbleiterschichtenfolge erheben, wobei die Erhebungen bevorzugt wenigstens einen Teil der Konversionsschichten umfassen. Die Aufrauung reicht insbesondere nicht bis an oder bis in die aktive Schicht. Mit anderen Worten ist die mindestens eine aktive Schicht nicht von der Aufrauung betroffen.

Erfindungsgemäß umfasst der optoelektronische Halbleiterchip eine Halbleiterschichtenfolge. Die Halbleiterschichtenfolge beinhaltet mindestens eine aktive Schicht zur Erzeugung einer Primärstrahlung. Weiterhin umfasst die Halbleiterschichtenfolge eine Mehrzahl von Konversionsschichten, wobei die Konversionsschichten dazu eingerichtet sind, die Primärstrahlung wenigstens teilweise zu absorbieren und in eine gegenüber der Primärstrahlung längerwellige Sekundärstrahlung umzuwandeln. Weiterhin weist die Halbleiterschichtenfolge eine Aufrauung auf, durch die ein Material der Konversionsschichten zum Teil entfernt ist.

Die Aufrauung stellt also insbesondere eine gezielte Materialwegnahme der Konversionsschichten dar. Durch eine Einstellung der Materialwegnahme der Konversionsschichten, also beispielsweise durch das Bestimmen einer mittleren Tiefe der Aufrauung, lässt sich zum Beispiel mitbestimmen, wie groß ein Anteil der Primärstrahlung ist, der die Halbleiterschichtenfolge verlässt, ohne von den Konversionsschichten absorbiert und in die Sekundärstrahlung umgewandelt zu werden. Das heißt, über insbesondere die mittlere Tiefe der Aufrauung ist ein Farbort einer vom Halbleiterchip emittierten Mischstrahlung effizient einstellbar. Durch die Aufrauung ist es somit möglich, durch die Änderung eines durch die Aufrauung nicht betroffenen Anteils der Konversionsschichten, einen Anteil der Sekundärstrahlung an einer vom Halbleiterchip emittierten Gesamtstrahlung einzustellen.

Es durchdringt die Aufrauung die Konversionsschichten, in einer Richtung hin zur mindestens einen aktiven Schicht, stellenweise vollständig. Mit anderen Worten weist die Aufrauung mindestens eine Ausnehmung auf, die die Konversionsschichten in Richtung zur mindestens einen aktiven Schicht hin so weit durchdringt, so dass sich zwischen der aktiven Schicht und einer tiefsten Stelle des Grabens keine Konversionsschicht oder kein Teil einer Konversionsschicht mehr befindet. Das heißt, die Konversionsschichten sind, in Draufsicht auf den optoelektronischen Halbleiterchip gesehen, stellenweise vollständig entfernt.

Gemäß zumindest einer Ausführungsform des optoelektronischen Halbleiterchips umfasst die Halbleiterschichtenfolge mindestens zwei Gruppen unterschiedlich gestalteter Konversionsschichten. Innerhalb einer Gruppe der Konversionsschichten sind die Konversionsschichten bevorzugt im Rahmen der Herstellungstoleranzen jeweils gleich gestaltet, so dass die Konversionsschichten der Gruppen zum Beispiel jeweils Sekundärstrahlung der gleichen Wellenlänge emittieren.

Gemäß zumindest einer Ausführungsform des optoelektronischen Halbleiterchips sind die Gruppen zur Erzeugung der Sekundärstrahlung in mindestens zwei voneinander verschiedenen Spektralbereichen gestaltet. Mit anderen Worten wird von einer der Gruppen eine Sekundärstrahlung mit einer ersten Wellenlänge und von einer zweiten der Gruppen der Konversionsschichten eine Sekundärstrahlung mit einer zweiten, von der ersten verschiedenen Wellenlänge emittiert. Beispielsweise emittiert eine der Gruppen von Konversionsschichten im grünen Spektralbereich und eine weitere der Gruppen im gelben Spektralbereich. Weiterhin ist es möglich, dass die Halbleiterschichtenfolge mehrere Gruppen, zum Beispiel genau drei Gruppen, aufweist, wobei eine Gruppe im grünen Spektralbereich um 550 nm, bevorzugt eine Gruppe im gelben Spektralbereich um 570 nm und insbesondere eine Gruppe der Konversionsschichten im roten Spektralbereich um 610 nm elektromagnetische Sekundärstrahlung aus der Primärstrahlung erzeugen. Durch die Verwendung mindestens zweier Gruppen von Konversionsschichten ist ein optoelektronischer Halbleiterchip aufbaubar, dessen Strahlung einen hohen Farbwiedergabeindex, beispielsweise einen Color Rendering Index, kurz CRI, von mindestens 85, aufweist.

Gemäß zumindest einer Ausführungsform des optoelektronischen Halbleiterchips emittiert der Halbleiterchip im Betrieb eine Mischstrahlung, die sowohl aus der Primärstrahlung als auch aus der Sekundärstrahlung gebildet ist. Die Primärstrahlung ist hierbei bevorzugt mindestens zum Teil durch blaues Licht gebildet.

Gemäß zumindest einer Ausführungsform des optoelektronischen Halbleiterchips ist dieser zur Emission von weißem Licht eingerichtet. Eine Farbtemperatur des vom Halbleiterchip emittierten weißen Lichts liegt bevorzugt zwischen einschließlich 2500 K und 6000 K, insbesondere zwischen einschließlich 2750 K und 4000 K.

Gemäß zumindest einer Ausführungsform des optoelektronischen Halbleiterchips umfasst die Halbleiterschichtenfolge höchstens 150 Konversionsschichten, bevorzugt zwischen einschließlich 10 und 50 Konversionsschichten, insbesondere zwischen einschließlich 20 und 35 Konversionsschichten. Die Konversionsschichten sind zum Beispiel als Multiquantentröge ausgeformt. Beispielsweise basieren die Konversionsschichten auf dem GaN/InGaN-Materialsystem. Liegen mehrere Konversionsschichten vor, so beträgt deren Dicke bevorzugt zwischen einschließlich 2 nm und 8 nm. Jede der Konversionsschichten absorbiert zum Beispiel zwischen einschließlich 3 % und 10 % der an die betreffende Konversionsschicht gelangende Primärstrahlung. Weist der Halbleiterchip genau eine Konversionsschicht auf, so beträgt deren Dicke bevorzugt mindestens 10 nm, insbesondere mindestens 14 nm.

Gemäß zumindest einer Ausführungsform des optoelektronischen Halbleiterchips ist die Aufrauung vollständig oder teilweise durch Erhebungen, zum Beispiel in Form von Pyramiden und/oder in Form von Pyramidenstümpfen, gebildet. Mit anderen Worten weist eine der aktiven Schicht abgewandte Oberseite des Halbleiterchips eine eierkartonartige Strukturierung auf, wobei aufragende Teile der Halbleiterschichtenfolge pyramidenartig oder pyramidenstumpfartig geformt sind.

Gemäß zumindest einer Ausführungsform des optoelektronischen Halbleiterchips sind die Pyramiden oder die Pyramidenstümpfe der Aufrauung hexagonal geformt. Die Aufrauung ist also bevorzugt durch hexagonale Pyramiden oder Pyramidenstümpfe gebildet.

Gemäß zumindest einer Ausführungsform des optoelektronischen Halbleiterchips weist die Aufrauung Gipfelbereiche und Talbereiche auf. Die Gipfelbereiche sind hierbei solche Bereiche der Aufrauung, die der aktiven Schicht am weitesten abgewandt sind, und die Talbereiche liegen am nächsten zur mindestens einen aktiven Schicht. In einer Richtung senkrecht zur mindestens einen aktiven Schicht ist es möglich, dass die Gipfelbereiche und die Talbereiche direkt aneinander grenzen. Beispielsweise sind die Gipfelbereiche der Aufrauung durch solche Bereiche gebildet, deren Eindringtiefe in die Halbleiterschichtenfolge höchstens 30 % oder höchstens 60 % der mittleren Tiefe der Aufrauung entspricht.

Gemäß zumindest einer Ausführungsform des optoelektronischen Halbleiterchips wird in den Gipfelbereichen eine Strahlung mit einem anderen Farbort emittiert als in den Talbereichen. Bevorzugt weist die in den Gipfelbereichen emittierte Strahlung einen geringeren Blauanteil auf als die in den Talbereichen emittierte Strahlung.

Gemäß zumindest einer Ausführungsform des optoelektronischen Halbleiterchips wird in den gesamten Gipfelbereichen der Aufrauung sowie in den gesamten Talbereichen der Aufrauung jeweils näherungsweise eine Strahlung mit einem vergleichbaren Farbort emittiert. Beispielsweise wird in den Gipfelbereichen gelb-weißes und in den Talbereichen blaues Licht emittiert. Die Aufteilung zwischen Gipfelbereichen und Talbereichen bezüglich deren Abstand zur mindestens einen aktiven Schicht kann also an das jeweilige emittierte Lichtspektrum gekoppelt sein. Die Talbereiche und die Gipfelbereiche sind dann beispielsweise lichtmikroskopisch oder nahfeldmikroskopisch unterscheidbar.

Gemäß zumindest einer Ausführungsform des optoelektronischen Halbleiterchips beträgt die mittlere Tiefe der Aufrauung zwischen einschließlich 0,2 µm und 3,5 µm, bevorzugt zwischen einschließlich 0,5 µm und 1,5 µm. Beispielsweise wird die mittlere Tiefe von einem höchsten Punkt der Aufrauung oder von einer ursprünglichen Oberseite der Halbleiterschichtenfolge aus gemessen.

Es wird darüber hinaus ein Verfahren zur Herstellung eines solchen optoelektronischen Halbleiterchips angegeben.

Das Verfahren umfasst die Schritte:
- Bereitstellen eines Aufwachssubstrates,
- epitaktisches Wachsen einer Halbleiterschichtenfolge auf dem Aufwachssubstrat, wobei die Halbleiterschichtenfolge mindestens eine aktive Schicht zur Erzeugung einer Primärstrahlung und eine Mehrzahl von Konversionsschichten, die die Primärstrahlung wenigstens zeitweise absorbieren und in eine gegenüber der Primärstrahlung langwelligere Sekundärstrahlung umwandeln, umfasst,
- Erzeugen einer Aufrauung, insbesondere an einer den Konversionsschichten zugewandten Seite der Halbleiterschichtenfolge, wobei die Aufrauung mindestens stellenweise bis in die Konversionsschicht reicht, so dass durch die Aufrauung ein Material der Konversionsschichten teilweise entfernt ist, und
- Fertigstellen des Halbleiterchips,
   wobei durch das Erzeugen der Aufrauung ein Farbort einer vom Halbleiterchip emittierten Strahlung geändert wird.

Mit anderen Worten wird die Halbleiterschichtenfolge mit den Konversionsschichten vollständig gewachsen. Anschließend wird über die Aufrauung der Farbort eingestellt. Je tiefer die Aufrauung erzeugt wird, desto mehr wird der Farbort der vom Halbeiterchip emittierten Strahlung beispielsweise ins Blaue verschoben.

Gemäß zumindest einer Ausführungsform des Verfahrens emittiert der Halbleiterchip zumindest zeitweise die Strahlung während des Erzeugens der Aufrauung. Weiterhin wird, ebenfalls zumindest zeitweise während des Erzeugens der Aufrauung, der Farbort der vom Halbleiterchip emittierten Strahlung gemessen. Es werden also während des Aufrauens beispielsweise die Konversionsschichten mit einer Lichtquelle mit definierter Wellenlänge, bevorzugt im ultravioletten oder blauen Spektralbereich, bestrahlt. Das von den Konversionsschichten abgestrahlte, langwelligere Licht wird dann etwa von einem Spektrometer detektiert und der Farbort der Strahlung wird bestimmt.

Hierdurch kann der jeweils aktuelle, der während der Messung vorliegenden Aufrauung zugrunde liegende, vom fertig gestellten Halbleiterchip dann emittierte Farbort der Strahlung bestimmt werden. Insbesondere kann das Erzeugen der Aufrauung beendet werden, wenn der einzustellende Farbort erreicht ist. Die Aufrauung ist hierdurch gezielt und effizient auf einen bestimmten, gewünschten Farbort der vom Halbleiterchip zu emittierenden Strahlung einstellbar. Der Farbort der Strahlung kann also von Herstellungstoleranzen der aktiven Schicht und der Konversionsschichten weitgehend unabhängig eingestellt werden.

Gemäß zumindest einer Ausführungsform des Verfahrens ändert sich während des Erzeugens der Aufrauung eine Summe aus einem c_{X}-Wert und c_{Y}-Wert des Farborts der vom Halbleiterchip emittierten Strahlung in der CIE-Normfarbtafel um mindestens 0,005 Einheiten, bevorzugt um mindestens 0,05 Einheiten, insbesondere um mindestens 0,07 Einheiten. Mit anderen Worten reduziert sich die Summe aus der Rot-Koordinate und der Grün-Koordinate des Farborts der Strahlung in der CIE-Normfarbtafel um den genannten Wert. Das heißt, die vom Halbleiterchip emittierte Strahlung wird während des Aufrauens bläulicher oder, im Hinblick auf die Farbtemperatur, kälter. Durch eine derart große Änderung der Summe aus der roten und der grünen Farbkoordinate in der CIE-Normfarbtafel ist gewährleistbar, dass auch bei größeren Herstellungstoleranzen bezüglich der aktiven Schicht und bezüglich der Konversionsschichten ein gewünschter Farbort der zu emittierenden Strahlung einstellbar ist.

Gemäß zumindest einer Ausführungsform des Verfahrens wird die gesamte Halbleiterschichtenfolge zusammenhängend auf dem Aufwachssubstrat gewachsen. Die Halbleiterschichtenfolge ist dann also durch eine einzige, insgesamt gewachsene Schichtenfolge gebildet, die zum Beispiel in einer einzigen Epitaxieanlage erzeugt ist und die sowohl die mindestens eine aktive Schicht als auch die Konversionsschichten umfasst.

Gemäß zumindest einer Ausführungsform des Verfahrens wird vor dem Erzeugen der Aufrauung das Aufwachssubstrat von der Halbleiterschichtenfolge entfernt. Beispielsweise wird die Halbleiterschichtenfolge vor dem Aufrauen auf ein Trägersubstrat, das die Halbleiterschichtenfolge mechanisch stützt, umgebondet.

Gemäß zumindest einer Ausführungsform des Verfahrens wird vor dem Erzeugen der Aufrauung der Halbleiterchip elektrisch kontaktiert. Mit anderen Worten ist die mindestens eine aktive Schicht der Halbleiterschichtenfolge bereits vor und/oder während dem Erzeugen der Aufrauung elektrisch betreibbar.

Gemäß zumindest einer Ausführungsform des Verfahrens wird während des Erzeugens der Aufrauung der Halbleiterchip mindestens zeitweise elektrisch betrieben. Die vom Halbleiterchip emittierte Strahlung kann dann gemessen werden und die Tiefe der Aufrauung ist im Hinblick auf einen gewünschten Farbort der zu emittierenden Strahlung genau einstellbar.

Gemäß zumindest einer Ausführungsform des optoelektronischen Halbleiterchips sind die mindestens eine aktive Schicht und die Konversionsschichten unabhängig voneinander in separaten Halbleiterschichtenfolgen epitaktisch gewachsen. Die beiden Halbleiterschichtenfolgen mit der mindestens einen aktiven Schicht und den Konversionsschichten sind dann beispielsweise über ein Waferbonden oder über ein Verbindungsmittel miteinander mechanisch fest verbunden.

Gemäß zumindest einer Ausführungsform des optoelektronischen Halbleiterchips ist die mindestens eine aktive Schicht und sind die Konversionsschichten monolithisch in einer einzigen Halbleiterschichtenfolge integriert. Monolithisch bedeutet, dass die gesamte Halbleiterschichtenfolge epitaktisch gewachsen ist und dass die Halbleiterschichtenfolge verbindungsmittelfrei ist, oder dass die Halbleiterschichtenfolge über ein verbindungsmittelfreies Bonden aus zwei oder mehreren Teilschichtfolgen gebildet ist.

Gemäß zumindest einer Ausführungsform des optoelektronischen Halbleiterchips basiert die gesamte Halbleiterschichtenfolge auf demselben Halbleitermaterial, zum Beispiel auf GaN. Hierdurch ist eine bessere Entwärmung der Konversionsschichten erzielbar. Weiterhin treten in der Halbleiterschichtenfolge dann keine größeren Sprünge des optischen Brechungsindexes auf, sodass eine effiziente optische Kopplung insbesondere zwischen der aktiven Schicht und der Konversionsschicht erreichbar ist. Außerdem ist ein Temperaturgang in der aktiven Schicht und in der Konversionsschicht gleich oder nahezu gleich. Des weiteren kann im optischen Fernfeld ein so genannter Farbsaum unterdrückt sein, das heißt, die vom Halbleiterchip emittierte Strahlung weist bezüglich eines Farborts keine oder im Wesentlichen keine Winkelabhängigkeit auf.

Nachfolgend wird ein hier beschriebener optoelektronischer Halbleiterchip sowie ein hier beschriebenes Verfahren unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1 und 2: eine schematische Schnittdarstellung (Figur 1) und eine schematische Draufsicht (Figur 2) eines Ausführungsbeispiels eines hier beschriebenen optoelektronischen Halbleiterchips,
- Figur 3: eine schematische Schnittdarstellung eines weiteren Ausführungsbeispiels eines hier beschriebenen optoelektronischen Halbeiterchips,
- Figur 4: eine schematische Darstellung eines hier beschriebenen Verfahrens zur Herstellung eines hier beschriebenen optoelektronischen Halbleiterchips,
- Figuren 5 bis 7: schematische Schnittdarstellungen von weiteren Ausführungsbeispielen von hier beschriebenen optoelektronischen Halbleiterchips, und
- Figuren 8: bis 11 schematische Schnittdarstellungen von nicht erfindungsgemäßen Abwandlungen von optoelektronischen Halbleiterchips.

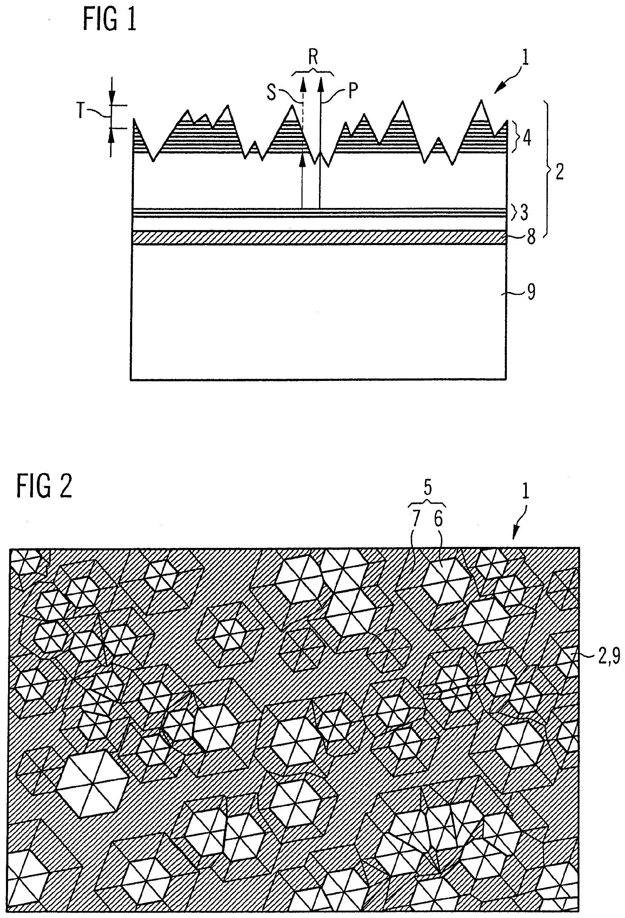

In Figur 1 ist ein erstes Ausführungsbeispiel eines Halbleiterchips 1 illustriert. Auf einem Träger 9 ist ein Spiegel 8 angebracht. Bei dem Spiegel 8 kann es sich um einen metallischen Spiegel oder auch um einen dielektrischen und metallischen Kombinationsspiegel handeln. An einer dem Träger 9 abgewandten Seite des Spiegels 8 befindet sich eine Halbleiterschichtenfolge 2. Die zum Beispiel epitaktisch gewachsene Halbleiterschichtenfolge 2 weist mindestens eine aktive Schicht 3 auf, die zur Erzeugung einer Primärstrahlung P mit einer Wellenlänge bevorzugt im blauen Spektralbereich oder im ultravioletten Spektralbereich eingerichtet ist.

An einer dem Träger abgewandten Seite der Halbleiterschichtenfolge 2 befinden sich weiterhin mehrere Konversionsschichten 4 in der Halbleiterschichtenfolge 2. Die Konversionsschichten 4 absorbieren mindestens einen Teil der Primärstrahlung P und wandeln diese in eine Sekundärstrahlung S um, wobei die Sekundärstrahlung S eine im Vergleich zur Primärstrahlung P größere Wellenlänge aufweist. An einer dem Träger 9 abgewandten Seite der Konversionsschichten 4 befindet sich ein weiteres Material der Halbleiterschichtenfolge 2, das beispielsweise zur Stromverteilung und/oder zur Bestromung der aktiven Schicht 3 dienen kann. Zur Vereinfachung der graphischen Darstellung sind elektrische Kontakte des Halbleiterchips 1 in Figur 1 nicht dargestellt.

Von einer dem Träger 9 abgewandten Seite der Halbleiterschichtenfolge 2 her ist eine Aufrauung 5 erzeugt. Die Aufrauung 5 wird beispielsweise durch eine Vielzahl von Gräben gebildet, die lokal die Dicke der Halbleiterschichtenfolge 2 reduzieren. Eine mittlere Tiefe T der Aufrauung 5, gemessen von einem tiefsten Punkt der Aufrauung 5 aus, beträgt beispielsweise zwischen einschließlich 0,2 µm und 3,5 µm. Die Gräben der Aufrauung durchdringen die Konversionsschichten 4 stellenweise vollständig, so dass sich zwischen Bereichen der Aufrauung 5, die dem Träger 9 am nächsten sind, und der aktiven Schicht 3 keine Konversionsschichten 4 mehr befinden.

Die Primärstrahlung P und die Sekundärstrahlung S mischen sich zu einer Mischstrahlung R. Die Mischstrahlung R ist beispielsweise durch weißes Licht gebildet. Insbesondere ein Anteil an der Primärstrahlung P, der in die Sekundärstrahlung S umgewandelt wird, ist durch die mittlere Tiefe T der Aufrauung einstellbar. Somit ist auch durch die mittlere Tiefe der Aufrauung T ein Farbort der Mischstrahlung R einstellbar.

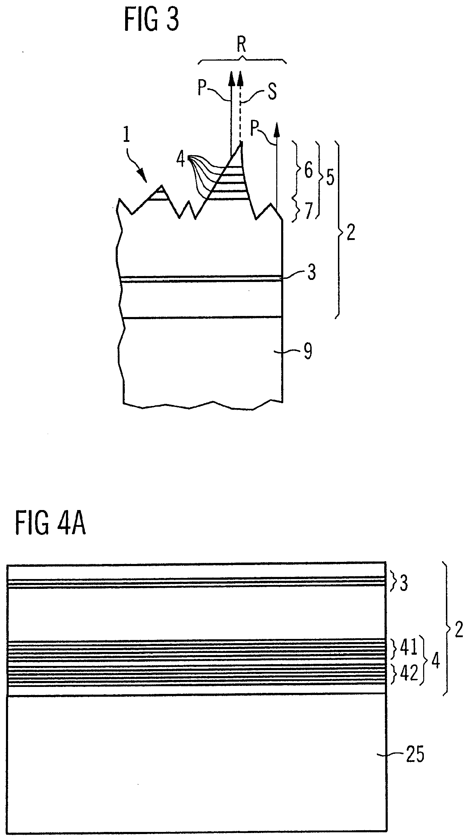

In Figur 2 ist eine Draufsicht auf den Halbleiterchip 1 gezeigt. Der Halbleiterchip 1 ist beispielsweise wie in Figur 1 dargestellt aufgebaut. Die Aufrauung ist durch hexagonale Pyramiden gebildet. In Draufsicht sind helle Bereiche und dunkle Bereiche der Aufrauung zu erkennen. Die hellen Bereiche werden durch Gipfelbereiche 6 der Aufrauung und die dunklen Bereiche durch Talbereiche 7 der Aufrauung gebildet, vergleiche auch Figur 3. Die Gipfelbereiche 6 sind hierbei solche Bereiche der Aufrauung, die weiter von der mindestens einen aktiven Schicht 3 entfernt sind als die Talbereiche 7. Mit anderen Worten reichen die Gipfelbereiche 6 von den Konversionsschichten 4, die den Gipfelbereichen 6 zuzuordnen sind, bis zu einer dem Träger 9 abgewandten Seite der Halbleiterschichtenfolge 2. Gemäß Figur 3 umfassen die Talbereiche 7 keine der Konversionsschichten 4.

Weiterhin unterscheiden sich die Gipfelbereiche 6 und die Talbereiche 7 insbesondere hinsichtlich eines Farborts der jeweiligen emittierten Strahlung. Es sind also dann die Gipfelbereiche 6 und die Talbereiche 7 durch deren spektrale Abstrahlcharakteristik voneinander unterscheidbar.

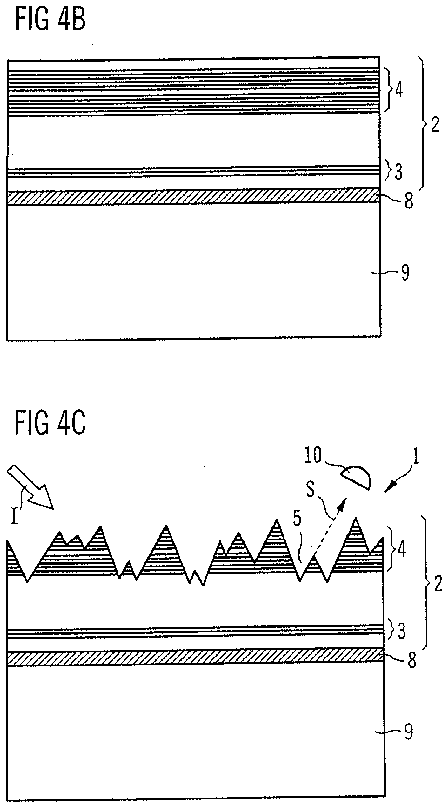

In Figur 4 ist schematisch ein Herstellungsverfahren für einen hier beschriebenen optoelektronischen Halbleiterchip 1 dargestellt. Auf einem Aufwachssubstrat 25 wird die Halbleiterschichtenfolge 2 epitaktisch aufgewachsen. In einer Richtung vom Aufwachssubstrat 25 weg wird eine erste Gruppe 42 und eine zweite Gruppe 41 der Konversionsschichten 4 aufgewachsen. Nachfolgend wird die mindestens eine aktive Schicht 3 epitaktisch hergestellt. Die Gruppen 41, 42 absorbieren die in der aktiven Schicht 3 erzeugte Primärstrahlung jeweils mindestens zum Teil. Die zweite Gruppe 41 emittiert dann beispielsweise grünes Licht und die erste Gruppe 42 gelbes Licht, jeweils aus der Primärstrahlung P erzeugt.

Gemäß Figur 4B wird die Halbleiterschichtenfolge 2 auf einen Träger 9 umgebondet, wobei sich zwischen der Halbleiterschichtenfolge 2 und dem Träger 9 der zum Beispiel metallische Spiegel 8 befindet.

Gemäß Figur 4C wird die Aufrauung 5 beispielsweise durch ein Ätzen hergestellt. Während des Herstellens der Aufrauung 5 werden, zumindest zeitweise, die Konversionsschichten 4 mit einer Beleuchtungsstrahlung I bestrahlt. Über die Strahlung I werden die Konversionsschichten zur Erzeugung einer Sekundärstrahlung S angeregt. Die Sekundärstrahlung S wird dann von einem Detektor 10, beispielsweise einem Spektrometer, detektiert. Aus dem Spektrum der Sekundärstrahlung S kann der Farbort der von dem fertigen Halbleiterchip 1 emittierten Strahlung bestimmt werden. Die Aufrauung 5 kann also gezielt derart eingestellt werden, dass der fertige Halbleiterchip 1 Strahlung mit einem bestimmten Farbort emittiert. Während des Erzeugens der Aufrauung ändert sich also der Farbort der vom Halbleiterchip 1 emittierten Sekundärstrahlung S.

Das Erzeugen der Aufrauung 5 erfolgt zum Beispiel nasschemisch, insbesondere ohne Zuhilfenahme von Masken, wobei bevorzugt pyramidenartige Strukturen entstehen. Alternativ hierzu ist es möglich, dass die Aufrauung 5 mittels phototechnischer Einbringung von Vertiefungen erzeugt wird. Dies erfolgt zum Beispiel durch ein trockenchemisches Ätzen in Verbindung mit einem Lack oder einer Hartmaske, etwa aus SiO₂, in den Figuren nicht dargestellt. Einzelne Strukturelemente der Aufrauung 5 können etwa in einem hexagonalen Raster angeordnet sein und insbesondere einen mittleren Durchmesser zwischen einschließlich 1 µm und 10 µm und einen Rasterabstand beispielsweise zwischen einschließlich 1 µm und 10 µm aufweisen.

Eine Einstellung eines Farborts der von dem Halbleiterchip 1 emittierten Mischstrahlung R kann dann durch unterschiedliche Ätztiefen und damit unterschiedliche Materialwegnahmen der Konversionsschichten 4 erreicht werden. Dem trockenchemischen Schritt kann ferner ein nasschemischer Schritt nachgeordnet sein, über den eine insbesondere laterale Vergrößerung der durch das trockenchemische Ätzen erzeugten Strukturelemente möglich ist. Eine Kontrolle des Farborts der von dem Halbleiterchip 1 zu emittierenden Mischstrahlung R ist zum Beispiel durch ein elektrisches Betreiben des Halbleiterchips 1 zwischen den verschiedenen Ätzschritten möglich.

Es ist, wie auch bei allen anderen Ausführungsbeispielen, nicht notwendig, dass die Aufrauung 5, die bis in zumindest eine der Konversionsschichten 4 reicht, auch zu einer deutlichen Verbesserung der Auskopplung der Mischstrahlung R aus dem Halbleiterchip 1 heraus dient. So können Flanken der Aufrauung 5 auch vergleichsweise steil sein und Winkel, bezogen auf eine Wachstumsrichtung der Halbleiterschichtenfolge 2, aufweisen, die zum Beispiel zwischen einschließlich 0° und 20° liegen. Mit anderen Worten sind dann laterale Begrenzungsflächen der Aufrauung 5 parallel oder nahezu parallel zu der Wachstumsrichtung orientiert. Dies kann insbesondere der Fall sein, wenn die Aufrauung 5 trockenchemisch erzeugt ist.

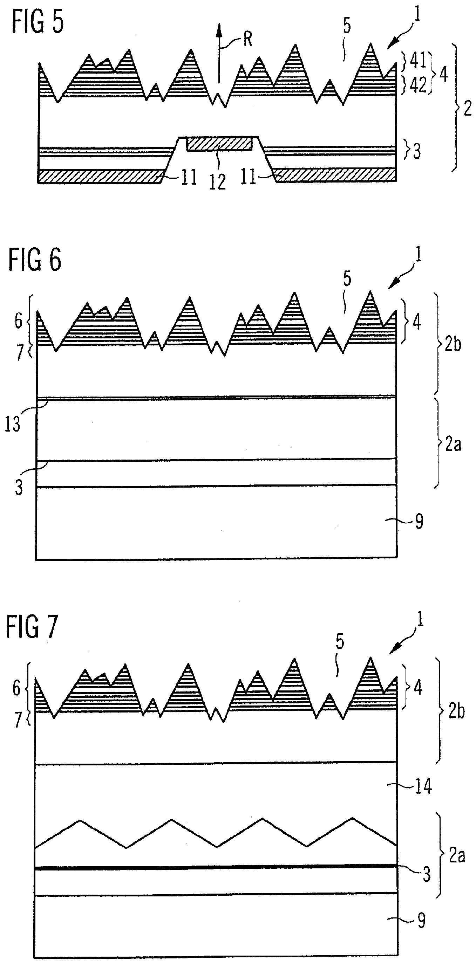

Bei dem Halbleiterchip 1 gemäß Figur 5 befinden sich an einer der Aufrauung 5 abgewandten Unterseite der Halbleiterschichtenfolge 2 elektrische Kontakte 11, 12. Die elektrischen Kontakte 11, 12 werden beispielsweise vor dem Entfernen des Aufwachssubstrats 25 gemäß Figur 4A, 4B erstellt. Hierdurch ist es ermöglicht, dass der Halbleiterchip 1 bereits vor dem Erzeugen der Aufrauung 5 elektrisch betreibbar ist. Während des Erzeugens der Aufrauung 5 wird der Halbleiterchip 1 zumindest zeitweise betrieben und die vom Halbleiterchip 1 emittierte Strahlung über etwa einen Detektor gemäß Figur 4C detektiert. Die Aufrauungen 5 gemäß den Figuren 4C und 5 durchdringen, im Gegensatz zur Aufrauung gemäß etwa Figur 1, die Konversionsschichten 4 nicht vollständig. Durch das elektrische Betreiben des Halbleiterchips 1 während des Erzeugens der Aufrauung ist also der Farbort der resultierenden Mischstrahlung R gezielt einstellbar.

Optional ist es möglich, dass etwa zwischen den elektrischen Kontakten 11 und der Halbleiterschichtenfolge 2 ein in Figur 5 nicht gezeichneter Träger 9 angebracht wird.

Beim Ausführungsbeispiel gemäß Figur 6 weist der Halbleiterchip 1 zwei voneinander verschiedene Halbleiterschichtenfolgen 2a, 2b auf, die bevorzugt unabhängig voneinander epitaktisch erzeugt sind. Die Halbleiterschicht 2a weist hierbei die mindestens eine aktive Schicht 3 auf, die Halbleiterschicht 2b umfasst die Konversionsschichten 4. Beide Halbleiterschichten 2a, 2b sind zum Beispiel über ein Waferbonden miteinander an einer Verbindungsebene 13 verbunden. Die Verbindung ist hierbei bevorzugt verbindungsmittelfrei.

Auch beim Ausführungsbeispiel des Halbleiterchips 1 gemäß Figur 7 weist dieser zwei voneinander verschiedene Halbleiterschichtenfolgen 2a, 2b auf. Die Halbleiterschichtenfolgen 2a, 2b sind über ein Verbindungsmittel 14 permanent und mechanisch fest miteinander verbunden. Über das Verbindungsmittel 14 erfolgt beispielsweise eine Brechungsindexanpassung, so dass die in der mindestens einen aktiven Schicht 3 erzeugte Primärstrahlung P effizient zu den Konversionsschichten 4 gelangen kann. Zum Beispiel ist das Verbindungsmittel 4 ein Silikon oder ein Silikon-Epoxid-Hybridmaterial.

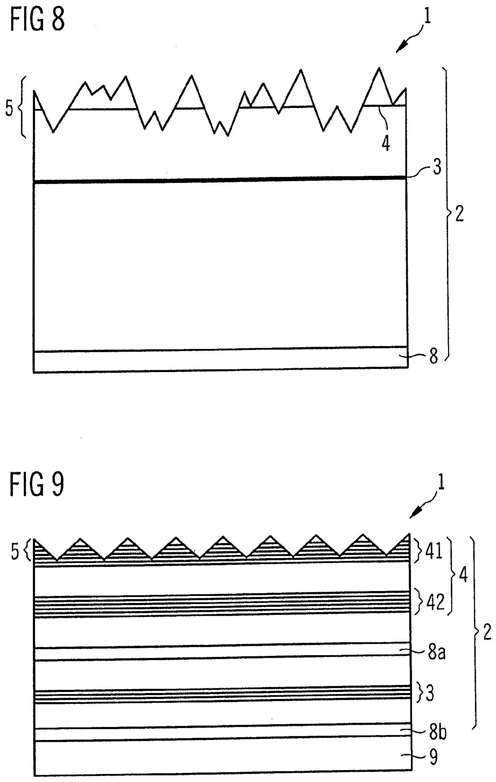

Bei der Abwandlung gemäß Figur 8 weist der Halbleiterchip 1 nur genau eine Konversionsschicht 4 auf. Eine Dicke der Konversionsschicht 4 übersteigt zum Beispiel 10 nm oder 14 nm. Weiterhin ist die Konversionsschicht 4 stellenweise durch die Aufrauung 5 vollständig durchdrungen. Die Halbleiterschichtenfolge 2 kann mechanisch selbsttragend und frei von einem weiteren Träger sein. Optional ist an einer der Aufrauung abgewandten Unterseite der Halbleiterschichtenfolge 2 der Spiegel 8 angebracht, der aus mehreren Schichten bestehen und der auch zu einer elektrischen Kontaktierung des Halbleiterchips 1 dienen kann. Auch durch den Spiegel 8 kann der Halbleiterchip 1 mechanisch stabilisiert sein, falls der Spiegel 8 zum Beispiel durch eine Metallschicht gebildet ist, die eine Dicke von beispielsweise mindestens 20 µm aufweist.

Der Halbleiterchip 1 gemäß der Abwandlung in Figur 9 weist zwei Gruppen 41, 42 von Konversionsschichten 4 auf. Die Gruppen 41, 42 sind, in Wachstumsrichtung der Halbleiterschichtenfolge 2 gesehen, räumlich voneinander beabstandet. Die Aufrauung 5 reicht hierbei nicht bis in die sich näher an den mehreren aktiven Schichten 3 befindliche Gruppe 42 heran. Zum Beispiel kann durch die Gruppe 41 rotes Licht und durch die Gruppe 42 gelbes Licht aus der Primärstrahlung erzeugt werden.

Zwischen den Gruppen 41, 42 und den aktiven Schichten 3 befindet sich bevorzugt der Spiegel 8a, der transmittierend bezüglich der Primärstrahlung und reflektierend bezüglich der Sekundärstrahlungen wirkt. Zum Beispiel ist der Spiegel 8a ein Bragg-Spiegel. Optional befindet sich zwischen der Halbleiterschichtenfolge 2 und dem Träger 9 der weitere Spiegel 8b.

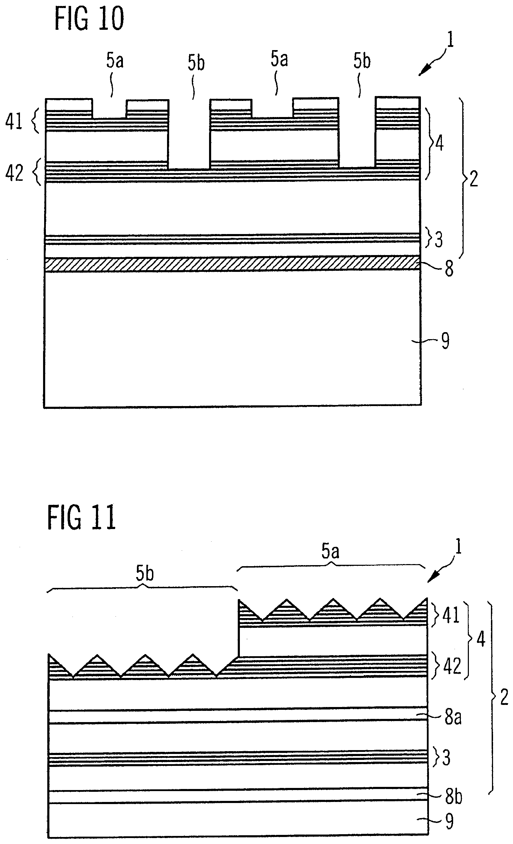

Bei der Abwandlung des Halbleiterchips 1 gemäß Figur 10 sind verschieden tiefe Aufrauungen 5a, 5b erzeugt, zum Beispiel über ein trockenchemisches Ätzen in Verbindung mit einer entsprechend strukturierten Maske, optional gefolgt von einem nasschemischen Ätzen. Die Aufrauung 5a reicht nur bis in weiter von der aktiven Schicht 3 entfernte Konversionsschicht 41. Die Aufrauung 5b durchdringt die Konversionsschicht 41 vollständig und reicht bis in die näher an der aktiven Schicht 3 befindliche Konversionsschicht 42. Die Aufrauungen 5a, 5b können auch, anders als in Figur 10 gezeigt, nicht nur abwechselnd sonder auch blockartig oder abschnittsweise angeordnet sein.

Gemäß Figur 11 ist im Bereich der Aufrauung 5b die Konversionsschicht 41 vollständig entfernt. Anders als dargestellt ist es auch möglich, dass die Aufrauung 5a bis in die Konversionsschicht 42 reicht. Die Bereiche mit den verschiedenen Aufrauungen 5a, 5b emittieren im Betrieb des Halbleiterchips 1 insbesondere Licht unterschiedlicher Farben.

Bei den Abwandlungen des Halbleiterchips 1 insbesondere gemäß den Figuren 10 und 11 ist es möglich, dass in verschiedenen Emissionsbereichen, die bevorzugt unterschiedliche Aufrauungen 5a, 5b aufweisen und die sich bevorzugt jeweils über mehrere der Strukturelemente der Aufrauung 5a, 5b erstrecken, Licht mit verschiedenen Farben emittiert wird, zum Beispiel kaltweißes, warmweißes, rotes, grünes und/oder blaues Licht. Ebenso ist es möglich, dass die verschiedenenfarbig emittierenden Emissionsbereiche einzeln und unabhängig voneinander elektrisch ansteuerbar sind, so dass durch einen einzigen, insbesondere zusammenhängend epitaktisch gewachsenen Halbleiterkörper zum Beispiel eine so genannte RGB-Leuchtdiode und/oder eine Leuchtdiode mit einer einstellbaren Farbtemperatur realisierbar ist.

Eine mittlere laterale Ausdehnung der Licht mit verschiedenen Farborten emittierenden Emissionsbereiche liegt zum Beispiel zwischen einschließlich 5 µm und 1 mm, insbesondere zwischen einschließlich 10 µm und 200 µm. Es ist möglich, dass der Halbleiterchip 1 jeweils mehrere Emissionsbereiche aufweist, die Licht mit, im Rahmen der Herstellungstoleranzen, demselben Farbort emittieren und die zu elektrisch gemeinsam ansteuerbaren Gruppen zusammengefasst sein können.

Die hier beschriebene Erfindung ist nicht durch die Beschreibung anhand der Ausführungsbeispiele beschränkt.

## Patentansprüche

1. Optoelektronischer Halbleiterchip (1) mit einer Halbleiterschichtenfolge (2), die aufweist:
- mindestens eine aktive Schicht (3) zur Erzeugung einer Primärstrahlung (P),
- eine Mehrzahl von Konversionsschichten (4), die die Primärstrahlung (P) wenigstens teilweise absorbieren und in eine gegenüber der Primärstrahlung (P) längerwellige Sekundärstrahlung (S) umwandeln, und
- eine Aufrauung (5),
**dadurch gekennzeichnet, dass**
die Aufrauung (5) die Konversionsschichten (4), in einer Richtung hin zur mindestens einen aktiven Schicht (3), stellenweise vollständig durchdringt.

2. Optoelektronischer Halbleiterchip (1) nach Anspruch 1, bei dem die Aufrauung (5) zufällig strukturiert ist.

3. Optoelektronischer Halbleiterchip (1) nach einem der vorhergehenden Ansprüche,
der mindestens zwei Gruppen (41, 42) unterschiedlich gestalteter Konversionsschichten (4) aufweist, wobei die Gruppen (41, 42) zur Erzeugung der Sekundärstrahlung (S) in mindestens zwei voneinander verschiedenen Spektralbereichen geeignet sind.

4. Optoelektronischer Halbleiterchip (1) nach einem der vorhergehenden Ansprüche,
bei der aus der Primärstrahlung (P) und der Sekundärstrahlung (S) eine vom Halbleiterchip (1) emittierte Mischstrahlung (R) gebildet ist.

5. Optoelektronischer Halbleiterchip (1) nach einem der vorhergehenden Ansprüche,
der zur Emission von weißem Licht eingerichtet ist.

6. Optoelektronischer Halbleiterchip (1) nach einem der vorhergehenden Ansprüche,
bei dem die Halbleiterschichtenfolge (2) zwischen einschließlich 10 und 50 Konversionsschichten (4) umfasst.

7. Optoelektronischer Halbleiterchip (1) nach einem der vorhergehenden Ansprüche,
bei dem die Aufrauung (5) vollständig oder teilweise durch hexagonale Pyramiden und/oder hexagonale Pyramidenstümpfe gebildet ist.

8. Optoelektronischer Halbleiterchip (1) nach einem der vorhergehenden Ansprüche,
bei dem an der wenigstens einen aktiven Schicht (3) abgewandten Gipfelbereichen (6) der Aufrauung eine Strahlung (P, S) mit einem anderen Farbort emittiert wird als an der wenigstens einen aktiven Schicht zugewandten Talbereichen (7) der Aufrauung (5).

9. Optoelektronischer Halbleiterchip (1) nach einem der vorhergehenden Ansprüche,
bei dem eine mittlere Tiefe (T) der Aufrauung (5) zwischen einschließlich 0,2 µm und 3,5 µm beträgt.

10. Optoelektronischer Halbleiterchip (1) nach einem der
vorhergehenden Ansprüche,
bei dem die mindestens eine aktive Schicht (4) und die Konversionsschichten (4) monolithisch integriert sind.

11. Verfahren zur Herstellung eines optoelektronischen Halbleiterchips (1) mit den Schritten:
- Bereitstellen eines Aufwachssubstrates (25),
- epitaktisches Wachsen einer Halbleiterschichtenfolge (2) auf dem Aufwachssubstrat (25), wobei die Halbleiterschichtenfolge (2) mindestens eine aktive Schicht (3) zur Erzeugung einer Primärstrahlung (P) und eine Konversionsschicht (4) oder eine Mehrzahl von Konversionsschichten (4), die die Primärstrahlung (P) wenigstens teilweise absorbieren und in eine gegenüber der Primärstrahlung (P) langwelligere Sekundärstrahlung (S) umwandeln, umfasst,
- Erzeugen einer Aufrauung (5), die die Konversionsschichten (4), in einer Richtung hin zur mindestens einen aktiven Schicht (3), stellenweise vollständig durchdringt, wobei durch das Erzeugen der Aufrauung (5) ein Material der Konversionsschichten (4) stellenweise entfernt wird, und
- Fertigstellen des Halbleiterchips (1),
wobei durch das Erzeugen der Aufrauung (5) ein Farbort einer vom Halbleiterchip (1) emittierten Strahlung (P, R, S) geändert wird.

12. Verfahren nach dem vorhergehenden Anspruch,
wobei während des Erzeugens der Aufrauung (5) der Halbleiterchip (1) zumindest zeitweise die Strahlung (R, S) emittiert und zumindest zeitweise der Farbort der vom Halbleiterchip (1) emittierten Strahlung (R, S) gemessen wird.

13. Verfahren nach Anspruch 11 oder 12,
wobei sich während des Erzeugens der Aufrauung (5) eine Summe aus einem cₓ-Wert und einem c_{y}-Wert des Farborts der vom Halbleiterchip (1) emittierten Strahlung (R) in der CIE-Normfarbtafel um mindestens 0,05 Einheiten verringert.

14. Verfahren nach einem der Ansprüche 11 bis 13,
wobei vor dem Erzeugen der Aufrauung (5) das Aufwachssubstrat (25) von der Halbleiterschichtenfolge (2) entfernt wird und der Halbleiterchip (1) vor dem Erzeugen der Aufrauung (5) elektrisch kontaktiert wird, und wobei der Halbleiterchip (1) während des Erzeugens der Aufrauung (5) zeitweise elektrisch betrieben wird.

## Claims

1. Optoelectronic semiconductor chip (1) having a semiconductor layer sequence (2) comprising:
- at least one active layer (3) for generating a primary radiation (P),
- a plurality of conversion layers (4) which at least partly absorb the primary radiation (P) and convert it into a secondary radiation (S) of longer wavelength compared with the primary radiation (P), and
- a roughening (5),
**characterized in that**
the roughening (5) in places completely penetrates through the conversion layers (4), in a direction towards the at least one active layer (3).

2. Optoelectronic semiconductor chip (1) according to Claim 1,
wherein the roughening (5) is randomly structured.

3. Optoelectronic semiconductor chip (1) according to either of the preceding claims,
which comprises at least two groups (41, 42) of differently fashioned conversion layers (4), wherein the groups (41, 42) are suitable for generating the secondary radiation (S) in at least two mutually different spectral ranges.

4. Optoelectronic semiconductor chip (1) according to any of the preceding claims,
wherein a mixed radiation (R) emitted by the semiconductor chip (1) is formed from the primary radiation (P) and the secondary radiation (S).

5. Optoelectronic semiconductor chip (1) according to any of the preceding claims,
which is configured for emitting white light.

6. Optoelectronic semiconductor chip (1) according to any of the preceding claims,
wherein the semiconductor layer sequence (2) comprises between 10 and 50 conversion layers (4) inclusive.

7. Optoelectronic semiconductor chip (1) according to any of the preceding claims,
wherein the roughening (5) is formed completely or partly by hexagonal pyramids and/or hexagonal truncated pyramids.

8. Optoelectronic semiconductor chip (1) according to any of the preceding claims,
wherein, at peak regions (6) of the roughening which face away from the at least one active layer (3), a radiation (P, S) having a different colour locus is emitted in comparison with at valley regions (7) of the roughening (5) which face the at least one active layer.

9. Optoelectronic semiconductor chip (1) according to any of the preceding claims,
wherein an average depth (T) of the roughening (5) is between 0.2 µm and 3.5 µm inclusive.

10. Optoelectronic semiconductor chip (1) according to any of the preceding claims,
wherein the at least one active layer (3) and the conversion layers (4) are monolithically integrated.

11. Method for producing an optoelectronic semiconductor chip (1) comprising the following steps:
- providing a growth substrate (25),
- epitaxially growing a semiconductor layer sequence (2) on the growth substrate (25), wherein the semiconductor layer sequence (2) comprises at least one active layer (3) for generating a primary radiation (P) and one conversion layer (4) or a plurality of conversion layers (4) which at least partly absorb the primary radiation (P) and convert it into a secondary radiation (S) of longer wavelength compared with the primary radiation (P),
- producing a roughening (5), which in places completely penetrates through the conversion layers (4), in a direction towards the at least one active layer (3), wherein a material of the conversion layers (4) is removed in places by the process for producing the roughening (5) and
- completing the semiconductor chip (1),
wherein a colour locus of a radiation (P, R, S) emitted by the semiconductor chip (1) is changed by the process of producing the roughening (5).

12. Method according to the preceding claim,
wherein, during the process of producing the roughening (5), the semiconductor chip (1) emits the radiation (R, S) at least at times and the colour locus of the radiation (R, S) emitted by the semiconductor chip (1) is measured at least at times.

13. Method according to Claim 11 or 12,
wherein, during the process of producing the roughening (5) a sum of a cₓ value and a c_{y} value of the colour locus of the radiation (R) emitted by the semiconductor chip (1) in the CIE standard chromaticity diagram decreases by at least 0.05 unit.

14. Method according to any of Claims 11 to 13,
wherein, before the process of producing the roughening (5) the growth substrate (25) is removed from the semiconductor layer sequence (2) and the semiconductor chip (1) is electrically contacted before the process of producing the roughening (5), and wherein the semiconductor chip (1) is electrically operated at times during the process of producing the roughening (5).

## Revendications

1. Puce en semiconducteur optoélectronique (1) comprenant une séquence de couches en semiconducteur (2), laquelle possède :
- au moins une couche active (3) destinée à générer un rayonnement primaire (P),
- une pluralité de couches de conversion (4) qui absorbent au moins partiellement le rayonnement primaire (P) et le convertissent en un rayonnement secondaire (S) à la longueur d'onde supérieure à celle du rayonnement primaire (P), et
- une rugosité (5),
**caractérisée en ce que**
la rugosité (5) traverse les couches de conversion (4) entièrement en certains endroits dans une direction vers l'au moins une couche active (3).

2. Puce en semiconducteur optoélectronique (1) selon la revendication 1, avec laquelle la rugosité (5) est structurée de manière aléatoire.

3. Puce en semiconducteur optoélectronique (1) selon l'une des revendications précédentes, laquelle possède au moins deux groupes (41, 42) de couches de conversion (4) de configurations différentes, les groupes (41, 42) étant adaptés pour générer le rayonnement secondaire (S) dans au moins deux plages spectrales différentes l'une de l'autre.

4. Puce en semiconducteur optoélectronique (1) selon l'une des revendications précédentes, avec laquelle un rayonnement mixte (R) émis par la puce en semiconducteur (1) est formé à partir du rayonnement primaire (P) et du rayonnement secondaire (S).

5. Puce en semiconducteur optoélectronique (1) selon l'une des revendications précédentes, laquelle est conçue pour l'émission de lumière blanche.

6. Puce en semiconducteur optoélectronique (1) selon l'une des revendications précédentes, avec laquelle la séquence de couches en semiconducteur (2) comprend de 10 à 50 couches de conversion (4).

7. Puce en semiconducteur optoélectronique (1) selon l'une des revendications précédentes, avec laquelle la rugosité (5) est entièrement ou partiellement formée par des pyramides hexagonales et/ou des pyramides tronquées hexagonales.

8. Puce en semiconducteur optoélectronique (1) selon l'une des revendications précédentes, avec laquelle, au niveau des zones des sommets (6) de la rugosité à l'opposé de l'au moins une couche active (3) est émis un rayonnement (P, S) ayant une localisation chromatique différente qu'au niveau des zones des vallées (7) de la rugosité (5) qui font face à l'au moins une couche active.

9. Puce en semiconducteur optoélectronique (1) selon l'une des revendications précédentes, avec laquelle une profondeur moyenne (T) de la rugosité (5) est comprise entre 0,2 µm et 3,5 µm inclus.

10. Puce en semiconducteur optoélectronique (1) selon l'une des revendications précédentes, avec laquelle l'au moins une couche active (4) et les couches de conversion (4) sont intégrées de manière monolithique.

11. Procédé de fabrication d'une puce en semiconducteur optoélectronique (1) comprenant les étapes suivantes :
- fourniture d'un substrat de croissance (25),
- croissance épitaxiale d'une séquence de couches en semiconducteur (2) sur le substrat de croissance (25), la séquence de couches en semiconducteur (2) comprenant au moins une couche active (3) destinée à générer un rayonnement primaire (P) et une couche de conversion (4) ou une pluralité de couches de conversion (4) qui absorbent au moins partiellement le rayonnement primaire (P) et le convertissent en un rayonnement secondaire (S) à la longueur d'onde supérieure à celle du rayonnement primaire (P),
- production d'une rugosité (5), laquelle traverse les couches de conversion (4) entièrement en certains endroits dans une direction vers l'au moins une couche active (3), un matériau des couches de conversion (4) étant enlevé en certains endroits par la production de la rugosité (5), et
- finition de la puce en semiconducteur (1),
une localisation chromatique d'un rayonnement (P, R, S) émis par la puce en semiconducteur (1) étant modifiée par la production de la rugosité (5).

12. Procédé selon la revendication précédente, le rayonnement (R, S) étant émis au moins occasionnellement pendant la production de la rugosité (5) dé la puce en semiconducteur (1) et la localisation chromatique du rayonnement (R, S) émis par la puce en semiconducteur (1) étant mesurée au moins occasionnellement.

13. Procédé selon la revendication 11 ou 12, une somme d'une valeur cₓ et d'une valeur c_{y} de la localisation chromatique du rayonnement (R) émis par la puce en semiconducteur (1) dans le diagramme de chromaticité CIE se réduisant d'au moins 0,05 unités pendant la production de la rugosité (5).

14. Procédé selon l'une des revendications 11 à 13, le substrat de croissance (25) étant retiré de la séquence de couches en semiconducteur (2) avant la production de la rugosité (5) et la puce en semiconducteur (1) étant mise en contact électrique avant la production de la rugosité (5), et la puce en semiconducteur (1) étant occasionnellement mise en fonctionnement électriquement pendant la production de la rugosité (5).
